# FASCICULE DE BREVET EUROPEEN

(11) **EP 2 332 326 B1**
(45) Date de publication et mention de la délivrance du brevet: **06.05.2015**
(21) Numéro de dépôt: 09748409.1
(22) Date de dépôt: 18.09.2009
(51) Int. Cl.: H04N 5/33, G01J 5/06, G01J 5/20, H01L 27/16, H01L 27/146

(54) **Réduction de rémanence dans un élément détecteur d'une matrice de bolomètres**
Verringerung der Remanenz in einem Detektorelement einer bolometrischen Sensormatrix
Reducing remanence in a detector element of a bolometric sensor matrix

(30) Priorité: 03.10.2008 FR 0856698
(43) Date de publication de la demande: 15.06.2011
(73) Titulaire: ULIS, 38113 Veurey Voroize (FR)
(72) Inventeur: CRASTES, Arnaud, F-38300 Maubec (FR)
(74) Mandataire: Vuillermoz, Bruno
(86) Numéro de dépôt international: PCT/FR2009/051758
(87) Numéro de publication internationale: WO 2010/037944

(56) Documents cités:
- US-A1- 2005 274 892
- US-A1- 2007 120 058
- US-B1- 6 515 285
- TROUILLEAU C ET AL: "35 mu m pitch at ULIS, a breakthrough" PROCEEDINGS OF THE SPIE, SPIE, BELLINGHAM, VA , US, vol. 5873, no. pt. II, 1 janvier 2005 (2005-01-01), pages 578-585, XP007904056 ISSN: 0277-786X

## Description

### DOMAINE DE L'INVENTION

La présente invention a trait au domaine de l'imagerie infrarouge et de la pyrométrie bolométrique.

Plus particulièrement, la présente invention concerne des dispositifs de détection de rayonnement électromagnétique, comportant des matrices d'éléments sensibles bolométriques, dits bolomètres élémentaires, ou plus simplement bolomètres, dont la résistance est commandée, notamment à des fins de réduction de phénomènes de rémanence.

### ETAT ANTERIEUR DE LA TECHNIQUE

Dans le domaine des détecteurs de rayonnements électromagnétiques, notamment infrarouges, il est connu d'utiliser des dispositifs agencés sous forme matricielle, et susceptibles de fonctionner à température ambiante, c'est-à-dire ne nécessitant pas de refroidissement à de très basses températures, contrairement aux dispositifs de détection appelés "détecteurs quantiques" qui eux, nécessitent un fonctionnement à très basse température, typiquement celle de l'azote liquide.

Ces détecteurs non refroidis utilisent traditionnellement la variation d'une grandeur physique d'un matériau approprié, en fonction de la température, au voisinage de 300K. Dans le cas des détecteurs bolométriques, cette grandeur physique est la résistivité électrique.

Un tel détecteur non refroidi associe généralement :
- des moyens d'absorption du rayonnement infrarouge et de conversion de celui-ci en chaleur ;
- des moyens d'isolation thermique du détecteur, de telle sorte à permettre à celui-ci de s'échauffer sous l'action du rayonnement infrarouge ;
- des moyens de thermométrie qui, dans le cadre d'un détecteur bolométrique, mettent en oeuvre un élément résistif ;
- et des moyens de lecture des signaux électriques fournis par les moyens de thermométrie.

Les détecteurs destinés à l'imagerie infrarouge sont classiquement réalisés sous la forme d'une matrice de détecteurs élémentaires, ou bolomètres, selon une ou deux dimensions, lesdits bolomètres prenant la forme de membranes suspendues au dessus d'un substrat, généralement réalisé en silicium, via des bras d'isolement thermique et de soutien ancrés au substrat.

Il est usuellement ménagé dans le substrat des moyens d'adressage séquentiel des détecteurs élémentaires et des moyens d'excitation électrique et de pré-traitement des signaux électriques générés par ces détecteurs élémentaires. Ce substrat et les moyens intégrés sont communément désignés par le terme « circuit de lecture ».

Classiquement, chaque bolomètre est connecté à un transistor de polarisation apte à injecter dans le bolomètre un courant, et à un intégrateur capacitif apte à intégrer le courant circulant dans le bolomètre pour la lecture de celui-ci.

Pour obtenir une image de la scène observée par l'intermédiaire de ce détecteur, on projette la scène à travers une optique adaptée sur la matrice de détecteurs élémentaires (le substrat est agencé au niveau du plan focal de cette optique), et des stimuli électriques cadencés sont appliqués par l'intermédiaire du circuit de lecture à chacun des détecteurs élémentaires, ou à chaque rangée de tels détecteurs, afin d'obtenir un signal électrique constituant l'image de la température atteinte par chacun desdits détecteurs élémentaires. Ce signal est traité de manière plus ou moins élaborée par le circuit de lecture, puis éventuellement par un dispositif électronique extérieur au boîtier afin de générer l'image thermique de la scène observée.

Les matériaux usuellement utilisés pour concevoir les bolomètres sont connus pour ne pas être thermiquement très stables. Aussi, lorsque les bolomètres comprenant ces matériaux sont soumis à des flux infrarouges trop importants (par exemple observation d'une source lumineuse très chaude comme le soleil ou un luminaire à incandescence), il apparait un décalage persistant de résistance après exposition, par rapport à la résistance avant exposition. La phase d'éclairement excessif est qualifiée de « surexposition », et les bolomètres concernés sont dits ensuite « surexposés ». La résistance d'un bolomètre surexposé tend ensuite à revenir à sa valeur initiale, mais sur une période de temps qui peut être problématique pour l'utilisateur. On parle alors de « rémanence » ou d'« effet mémoire ». Le signal de sortie (dit niveau continu ou « NC » lorsque le détecteur est placé devant une scène uniforme) du détecteur en provenance de ces bolomètres est alors décalé par rapport aux signaux (NC) en provenance des autres bolomètres de la matrice, ce décalage peut aller jusqu'à une saturation du signal.

En outre, indépendamment de ce phénomène, les bolomètres ne sont pas strictement identiques et présentent classiquement des sensibilités et des niveaux continus différents. Ces dispersions de sensibilité et de niveau continu sont usuellement corrigées par l'utilisation de tables de gains et d'offsets établies lors d'une calibration du détecteur en usine (on parle alors de correction « 2 points »).

La correction d'offset pour sa part est typiquement fréquemment renouvelée lors du fonctionnement du système (caméra par exemple) par fermeture temporaire d'un obturateur (« *shutter* ») qui fournit une scène de référence uniforme, il en résulte qu'après une phase de surexposition, tant que le signal n'est pas saturé, c'est à dire tant qu'il reste dans les limites de la dynamique électrique le l'électronique de traitement, l'effet de rémanence n'est plus visible sur l'image, au moins pour des scènes de faible dynamique, dès qu'une correction d'offset est appliquée.

Par contre, le décalage rémanent de résistance produit d'une part une perte de dynamique de scène des bolomètres surexposés par suite du décalage de l'offset, et d'autre part un décalage de sensibilité desdits bolomètres, qui peut perturber durablement la qualité des signaux : la surexposition des bolomètres a pour effet de rendre les tables de correction de gain au moins temporairement invalides.

La durée du phénomène de rémanence dépend du flux incident sur le bolomètre ainsi que de la durée d'exposition de ceux-ci. Cette durée de rémanence peut être très longue, jusqu'à plusieurs mois, alors même que le bolomètre n'est pas détruit.

Pour remédier au phénomène de rémanence, il a été proposé de détecter en cours d'exposition la présence de bolomètres surexposés, et de limiter cette surexposition par l'emploi de filtres absorbants saturables et/ou d'un obturateur mécanique de manière à protéger les éléments sensibles. Toutefois, ces techniques font perdre l'usage du détecteur pendant la durée d'application de la protection, par exemple lors de la fermeture de l'obturateur, et nécessitent des circuits électroniques et mécaniques supplémentaires. Or, la non-disponibilité du détecteur est préjudiciable dans certaines applications, de sorte que la durée de perte de l'image doit être la plus courte possible. Dans le document US-A-2005/0274892, il a été proposé de réduire le phénomène de rémanence d'un détecteur bolométrique en portant temporairement la température du plan focal, et donc aussi celle des bolomètres, à une température supérieure à celle à laquelle étaient soumis les bolomètres surexposés pendant leur surexposition, par la mise en oeuvre d'un module Peltier, ou module TEC (acronyme de l'expression anglo-saxonne « *Thermo-E*/*ectric Cooler* ») pour chauffer le plan focal.

Dans le même domaine technique de détecteurs bolométriques le document US-A-2007/0120058 divulgue des méthodes diverses pour réduire des effets indésirables thermiques. On propose un étalonnage qui peut comprendre la variation de la fréquence trame, ou du temps d'intégration, pour adapter le détecteur aux conditions variables des scènes à acquérir et pour accélérer l'acquisition d'images. On propose de limiter l'acquisition à une fenêtre ne comprenant qu'une part des bolomètres disponibles, et de réduire le phénomène de rémanence par le remplacement d'une valeur du niveau continu d'un bolomètre individuel par une valeur moyenne des niveaux continus des bolomètres avoisinants.

Toutefois, outre le fait rédhibitoire que les composants bolométriques d'aujourd'hui sont de plus en plus souvent dépourvus de module Peltier, ce qui implique de disposer d'autres méthodes de traitement, on observe que l'élimination des phénomènes de rémanence utilisant une telle technique prend plusieurs secondes, voire plusieurs minutes. En effet, cette technique utilise plusieurs étapes de chauffage successives pour porter le plan focal à une température souhaitée de manière stable. En outre, le chauffage par module Peltier est coûteux en énergie de par l'utilisation d'un courant élevé, pulsé notamment, qui induit des appels de courant qui contraignent les éléments électroniques de commande. Enfin, la température du plan focal (TPF) est modifiée, et le retour de la TPF à une valeur proche de sa valeur avant la mise oeuvre du protocole précédemment décrit nécessite une attente relativement prolongée. Or, les tables de gains et d'offsets utilisées pour la correction des dispersions des bolomètres dépendent de cette température. La modification de la température du plan focal nécessite donc de prévoir des tables pour plusieurs configurations si la disponibilité de l'image doit être préservée pendant le processus de traitement de rémanence. L'établissement des tables de correction est cependant délicat et coûteux en temps.

Il a également été proposé dans ce document de réduire le phénomène de rémanence en modifiant les paramètres du circuit de lecture réglant la quantité de courant circulant dans le bolomètre. Dans ce dernier cas, une polarisation du bolomètre et un temps d'intégration (ou plus exactement, un temps d'adressage) supérieurs sont ainsi utilisés pour échauffer le bolomètre et ainsi réduire les phénomènes de rémanence.

Toutefois, la marge de puissance disponible offerte par ces méthodes pour échauffer les bolomètres est relativement limitée, car autant la polarisation que le temps d'intégration nominaux mis en oeuvre lors de l'utilisation normale, sont habituellement choisis de manière à optimiser les performances du détecteur. De fait, les meilleures performances sont typiquement obtenues pour la polarisation maximale offerte par le circuit de lecture, et le temps d'intégration le plus long compatible avec la fréquence trame. Il n'est donc pas particulièrement aisé de modifier ces paramètres pour maîtriser l'échauffement des bolomètres au-delà du point de repos nominal.

### EXPOSE DE L'INVENTION

Le but de la présente invention est de résoudre les problèmes susmentionnés en proposant un procédé de commande de la résistance d'un ou plusieurs bolomètre(s) d'un détecteur matriciel du type précité, qui soit rapide et qui ne modifie pas le point de fonctionnement de celui-ci, ledit détecteur comportant un circuit de lecture apte à adresser ledit ou lesdits bolomètre(s).

Selon l'invention, qui est telle que définie par le procédé de la revendication 1 et le détecteur bolométrique de la revendication 9, le procédé comporte une étape de réglage de la récurrence d'adressage du bolomètre par le circuit de lecture.

Ici le terme « adressage » combine la notion classique d'adressage d'une matrice de bolomètres, visant à « désigner », par une commande appropriée d'interrupteurs, les bolomètres qui vont être sollicités, et l'envoi de courant dans les bolomètres ainsi désignés.

Ce terme peut, pour simplifier, être assimilé au temps d'intégration de l'état de l'art, lequel est en toute rigueur à comprendre comme le temps pendant lequel est intégré le courant traversant le bolomètre. Il est cependant bien clair que l'échauffement du bolomètre adressé est lié au temps d'application du courant de polarisation, et donc au « temps d'adressage », quel que soit le temps d'intégration.

La « fréquence trame » fₜᵣₐₘₑ désigne, comme cela est connu en soi, l'inverse du temps écoulé entre deux rafraichissements consécutifs du flux vidéo en sortie du circuit de lecture. La fréquence trame correspond donc au nombre d'images, ou « trames », délivrées par le détecteur en l'espace d'une seconde.

Dans la majorité des détecteurs, et comme cela est le cas des modes de réalisation décrits ci-après, un bolomètre (ou pixel, pour retenir un terme courant en imagerie) n'est adressé qu'une seule fois par trame. Ainsi, dans le cadre de tels modes de réalisation, la fréquence trame règle également le nombre d'adressages par seconde d'un bolomètre dont on souhaite commander la résistance selon le procédé de l'invention.

En d'autres termes, dans de tels détecteurs, le réglage de la fréquence d'adressage d'un bolomètre, selon ces définitions, revient en pratique au réglage de la fréquence trame fₜᵣₐₘₑ.

La « fréquence ligne » f_{ligne} désigne l'inverse du temps écoulé entre la lecture de deux lignes consécutives d'une même trame par le circuit de lecture. Ledit temps écoulé est compris en relation avec le même événement du chronogramme de commande, vu d'une ligne à la suivante. D'un point de vue mathématique, la fréquence ligne correspond au nombre de lignes consécutives d'une même trame lues par le circuit de lecture en l'espace d'une seconde. La fréquence ligne est usuellement associée au cas d'un circuit de lecture à balayage ligne par ligne, et où tous les pixels d'une même ligne sont adressés simultanément.

La « fréquence pixel » fₚᵢₓₑₗ désigne le nombre prédéterminé de pixels consécutifs adressés par le circuit de lecture en l'espace d'une seconde. Ce terme n'est employé ici que dans le cas d'un circuit de lecture à balayage pixel par pixel, ou autrement dit, à adressage sériel.

Dans l'état de la technique décrit ci-dessus, et dans le cadre particulier de l'élimination de la rémanence, un chauffage des bolomètres était notamment effectué en modifiant l'amplitude et/ou la durée du courant les traversant. Dans le cas de la présente invention, le chauffage global du plan focal n'est pas nécessaire, et on peut ainsi appliquer l'invention aux dispositifs modernes qui sont dépourvus du module Peltier mentionné dans l'art antérieur.

Selon l'invention, une commande de la résistance d'un bolomètre est effectuée également en élevant temporairement la température de celui-ci, mais par le biais d'une injection de courant plus fréquente, les caractéristiques du courant restant par ailleurs, dans un mode de réalisation privilégié, inchangées. Selon des modes particuliers de mise en oeuvre de l'invention, il est cependant possible d'utiliser conjointement à une injection plus fréquente de courant, une variation de tension de polarisation ou/et de temps d'adressage de manière à disposer d'un ou deux leviers supplémentaires pour ajuster la résistance du bolomètre. De même, conjointement à une injection de courant plus fréquente, il est possible d'élever la température du plan focal par contrôle du module Peltier.

Les caractéristiques du circuit de lecture restent donc inchangées, et notamment, la polarisation et le temps d'intégration dans la forme préférentielle de l'invention, limitée à la variation de la fréquence d'injection de courant. Comme le point de fonctionnement des bolomètres ainsi que la température du plan focal demeurent inchangés, il n'est donc pas nécessaire de prévoir plusieurs tables de gains et d'offsets.

Dans le cadre d'une réduction de la rémanence, le demandeur a en outre observé que le procédé selon l'invention permet un gain de temps substantiel. Ainsi, il est possible grâce au procédé de l'invention de corriger un phénomène de rémanence en quelques dizaines de millisecondes, contre quelques secondes voire minutes pour l'état antérieur de la technique. Ce processus de correction, est traduit par le terme « ajuster » appliqué à la résistance du bolomètre, utilisé dans le contexte de ce document.

De plus, il est possible grâce au procédé selon l'invention d'obtenir des températures plus élevées pour les bolomètres que celles usuellement obtenues dans l'état antérieur de la technique. Ainsi, le demandeur a expérimenté qu'il est facilement possible par exemple, au moins dans le cas de détecteurs modernes dont les membranes bolométriques présentent de hautes résistances thermiques, de porter les bolomètres à une température au moins 180°C supérieure à celle du plan focal, alors que l'élévation de température dans l'état de la technique au moyen du module Peltier n'atteint raisonnablement que quelques dizaines de °C. En effet, imposer un courant très élevé dans les modules Peltier afin d'obtenir éventuellement des écarts de température supérieurs, n'est pas sans risques en regard de la probabilité de défaillance du détecteur par perte d'intégrité du module lui-même ou d'autres éléments du dispositif, ou encore au niveau de la qualité du vide dans le boîtier du détecteur après l'opération. En outre, la dissipation de puissance très importante induit un flux thermique qui se propage dans le corps de boîtier et au-delà dans le système, ce qui est aussi relativement contraignant pour le système, en termes de sollicitation thermo-mécanique et de temps de retour aux conditions antérieures.

Selon l'invention, l'étape de réglage comporte :
▪ la sélection au moyen du circuit de lecture d'une fenêtre de la matrice de bolomètres, ladite fenêtre comprenant le bolomètre et ayant un nombre de lignes L inférieur au nombre total N de lignes de la matrice de bolomètres ;
▪ la sélection au moyen du circuit de lecture d'une fréquence trame fₜᵣₐₘₑ telle que fₜᵣₐₘₑ ≤ f_{ligne}/L et correspondant à la récurrence d'adressage souhaitée, où f_{ligne} est une fréquence ligne prédéterminée ; et
▪ la lecture récurrente par le circuit de lecture à la fréquence fₜᵣₐₘₑ des L lignes consécutives de la fenêtre sélectionnée, à la fréquence ligne f_{ligne} prédéterminée, de sorte que le nombre de lignes inférieur de la fenêtre produit un adressage plus fréquent de chaque ligne de celle-ci et donc une augmentation de la récurrence d'adressage du bolomètre.

En d'autres termes, le détecteur conforme à l'invention est capable de fenêtrer librement la matrice de bolomètres et de lire les bolomètres compris dans une telle fenêtre ligne par ligne. De même, le détecteur selon l'invention est capable de piloter la fréquence trame indépendamment de la fréquence ligne. En choisissant une fenêtre dont au moins la « hauteur » L est réduite (par rapport au plein format M), le temps mis pour adresser l'ensemble des lignes de la fenêtre est donc réduit, de sorte qu'une ligne de la fenêtre, et donc les bolomètres la constituant, est adressée plus fréquemment. Un courant circule donc plus souvent dans les bolomètres de la fenêtre. Les dimensions de la fenêtre permettent ainsi de régler la récurrence d'adressage, et donc l'échauffement subi par les bolomètres.

La récurrence la plus fréquente pour une fenêtre de hauteur L donnée, et donc l'échauffement le plus élevé pour ladite fenêtre, est obtenue dans le cas où fₜᵣₐₘₑ est choisie égal à f_{iigne}/L, qui correspond au retour immédiat à la première ligne en fin de trame, comme si les dernière et première lignes étaient adjacentes.

La récurrence la plus élevée réalisable, et donc l'échauffement le plus élevé réalisable, est obtenue selon le choix particulier L = 1 et fₜᵣₐₘₑ = f_{ligne}, qui correspond à l'adressage récurrent d'une seule et même ligne à la fréquence ligne prédéterminée.

La valeur de la fréquence fₜᵣₐₘₑ est habituellement réglée par la fréquence de récurrence d'une impulsion digitale particulière, indépendante des autres commandes de cadencement, formée par la logique du circuit de lecture et ordinairement dénommé « synchronisation trame », qui déclenche le retour du balayage à la première ligne de la matrice. En conséquence, toutes les configurations satisfaisant la relation fₜᵣₐₘₑ ≤ f_{ligne}/L sont accessibles aux circuits de lecture pourvus des fonctions de fenêtrage programmable et de réglage de la fréquence trame. Dans le cas général où le temps total de balayage de la fenêtre est inférieur au temps trame, il existe un temps « d'attente » pendant lequel aucune ligne n'est adressée entre deux trames successives, avec d'autant plus de latitude qu'un fenêtrage sur un nombre de lignes inférieur au plein format M de la matrice est mis en oeuvre. Au point limite fₜᵣₐₘₑ = f_{ligne}/L, le balayage de la fenêtre est ininterrompu.

Selon l'invention, le procédé comporte, préalablement à l'étape de réglage de la récurrence d'adressage, une étape de sélection du bolomètre selon une comparaison entre son niveau continu et la moyenne des niveaux continus de l'ensemble des bolomètres de la matrice, le bolomètre étant sélectionné si cette différence est supérieure à un seuil prédéterminé.

En d'autres termes, le procédé s'applique avantageusement à la réduction de la rémanence induite par une surexposition. Une étape préliminaire de détection des bolomètres surexposés permet ainsi de ne régler le NC, image de la résistance, que de ceux-ci.

Ceci est particulièrement avantageux dans le cas où un fenêtrage est réalisé. En effet, usuellement la matrice et son circuit de lecture associé sont intégrés dans une enceinte hermétique placée sous une pression réduite, idéalement très faible. L'échauffement de certains éléments a pour effet de libérer des gaz adsorbés ou dissous, réduisant de fait la durée de vie du détecteur. Ainsi, un nombre réduit d'éléments chauffés limite en proportion la diminution de durée de vie du détecteur.

Selon un mode de réalisation particulier préférentiel de l'invention, lors du réglage de la récurrence d'adressage du bolomètre, le procédé comporte une étape de fermeture d'un obturateur équipant le détecteur ou bien le procédé comporte une étape de défocalisation

En d'autres termes, la fermeture de l'obturateur coupe le flux incident sur tous les bolomètres, et en particulier sur les bolomètres surexposés, permettant ainsi d'adresser ces derniers sans ajouter d'effet parasite supplémentaire.

Selon un mode des modes de réalisation particuliers de l'invention, la récurrence d'adressage est variable et comporte au moins une première et une seconde phase, la valeur de la récurrence d'adressage dans la première phase étant différente de la valeur de la récurrence d'adressage dans la seconde phase.

De cette manière, il est possible de commander la résistance du bolomètre de manière plus précise.

Selon un mode de réalisation particulier de l'invention, le procédé comporte en outre une étape de modification des caractéristiques de polarisation du bolomètre, notamment sa tension de polarisation.

Selon un mode de réalisation particulier de l'invention, le procédé comporte en outre une étape de modification de la durée au cours de laquelle le bolomètre est parcouru par un courant lors de l'adressage de celui-ci.

Selon un mode de réalisation particulier de l'invention, le procédé comporte en outre une étape de chauffage du bolomètre par une source de chaleur externe à celui-ci, notamment une source de chaleur du type Peltier.

L'invention a également pour objet un détecteur bolométrique comprenant une matrice de bolomètres et un circuit de lecture de la matrice apte à adresser chaque bolomètre de celle-ci. Selon l'invention, le circuit de lecture est apte à régler la résistance de chaque bolomètre de la matrice par un réglage de la récurrence d'adressage de celui-ci.

En d'autres termes, le détecteur bolométrique est apte à mettre en oeuvre un procédé du type précité.

### BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
- la figure 1 est une vue schématique d'une matrice de bolomètres associés à un circuit de lecture ;
- la figure 2 représente une fenêtre locale inscrite dans la matrice complète ;
- la figure 3 est un organigramme d'un procédé selon l'invention ; et
- la figure 4 est un exemple de tracé de la température d'un bolomètre, en fonction du temps, obtenu par le procédé selon l'invention.

### DESCRIPTION DETAILLEE DE L'INVENTION

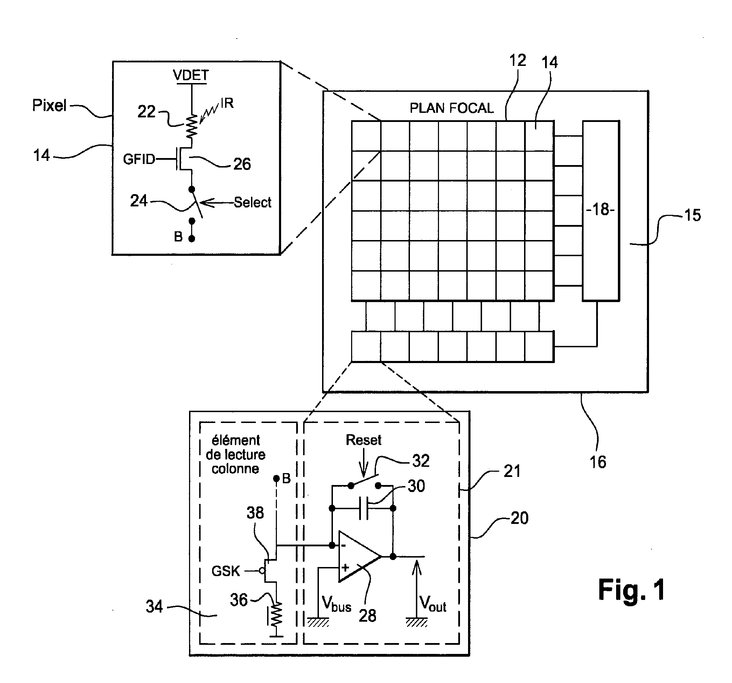

On a illustré schématiquement sur la figure 1 un détecteur bolométrique qui comprend une matrice bidimensionnelle **12** d'imagerie comprenant M lignes et N colonnes de pixels bolométriques **14,** où N et M sont des entiers supérieurs ou égaux à 1. La matrice d'imagerie **12** est agencée dans le plan focal **16** d'une optique transparente au rayonnement infrarouge (non représentée).

Le détecteur comprend également un circuit de lecture **15** réalisé dans un substrat agencé dans le plan focal **16,** lequel supporte la matrice d'imagerie **12.** Le circuit de lecture **15** comprend un circuit d'adressage **18** des pixels **14** de la matrice **12,** et, pour chaque colonne de celle-ci, un élément de lecture **20** apte à être connecté à chaque pixel **14** de la colonne par des moyens électriques.

Chaque pixel **14** comprend un bolomètre résistif **22,** soumis à un rayonnement infrarouge « IR », et connecté à l'une de ses bornes à une tension constante V_{DET} prédéterminée. Le pixel **14** comprend également un interrupteur **24** de lecture, pilotable au moyen d'un signal « *Select* » émis par le circuit d'adressage **18,** et un transistor MOS **26** d'injection, dont la grille est mise à une tension GFID constante prédéterminée, dont la source est connectée à l'autre borne du bolomètre **22,** et dont le drain est connecté à l'une des bornes du premier interrupteur **24** de sélection.

L'élément de lecture **20** comprend quant à lui un intégrateur **21** formé :
- d'un amplificateur opérationnel **28** dont l'entrée non inverseuse (+) est mise à une tension constante Vbus prédéterminée, et dont l'entrée inverseuse (-) est connectée à l'autre borne de l'interrupteur de lecture **24 ;**
- d'un condensateur **30,** de capacité *C*ᵢₙₜ prédéterminée, connecté entre l'entrée inverseuse (-) de l'amplificateur **28** et la sortie de celui-ci ; et
- d'un interrupteur de remise à zéro **32** connecté en parallèle du condensateur **30,** et pilotable au moyen d'une commande « *Reset ».*

L'élément de lecture **20** comporte également une colonne de compensation (désigné également par le terme « d'ébasage ») **34** comprenant un bolomètre de compensation **36,** réalisé dans le même matériau que le bolomètre **22** et présentant une faible résistance thermique vers le substrat, et un transistor MOS **38** d'injection pour la polarisation du bolomètre de compensation **36.** La colonne de compensation **34** a pour effet de produire un courant dit de compensation de mode commun, (correspondant à l'expression anglo-saxonne « *skimming* »), comme cela est connu en soi de l'état de la technique.

Dans l'exemple illustré, la matrice **12** de pixels **14** est lue ligne par ligne, la lecture d'une ligne de pixels comprenant sa connexion aux colonnes de compensation **34,** comme cela est connu en soi.

Plus particulièrement, au début d'un cycle de lecture d'un bolomètre **22** d'une ligne en cours de lecture, l'interrupteur de remise à zéro **32,** qui est à l'état fermé suite à un cycle de décharge du condensateur **30,** est basculé à l'état ouvert par réglage de la commande « *Reset* » à une valeur appropriée.

L'interrupteur **24** de lecture, qui est dans l'état ouvert, est basculé à l'état fermé par réglage de la commande « *Select* », et un courant traverse le bolomètre **22,** dont la polarisation est ajustée par le transistor MOS **26** par une commande appropriée de la tension de grille GFID. Cette séquence est désignée par l'expression « adressage » du bolomètre **22.** La durée de polarisation est donc imposée par la durée de la phase de fermeture de cet interrupteur **24.**

Le courant traversant le bolomètre **22** est alors intégré par le condensateur **30** après soustraction du courant traversant le bolomètre de compensation **36** dont la polarisation est ajustée par le transistor MOS **38.** Lorsqu'une durée d'intégration Δ*T*ᵢₙₜ prédéterminée s'est écoulée depuis le début du cycle de lecture, l'interrupteur d'adressage **24** est basculé dans son état ouvert.

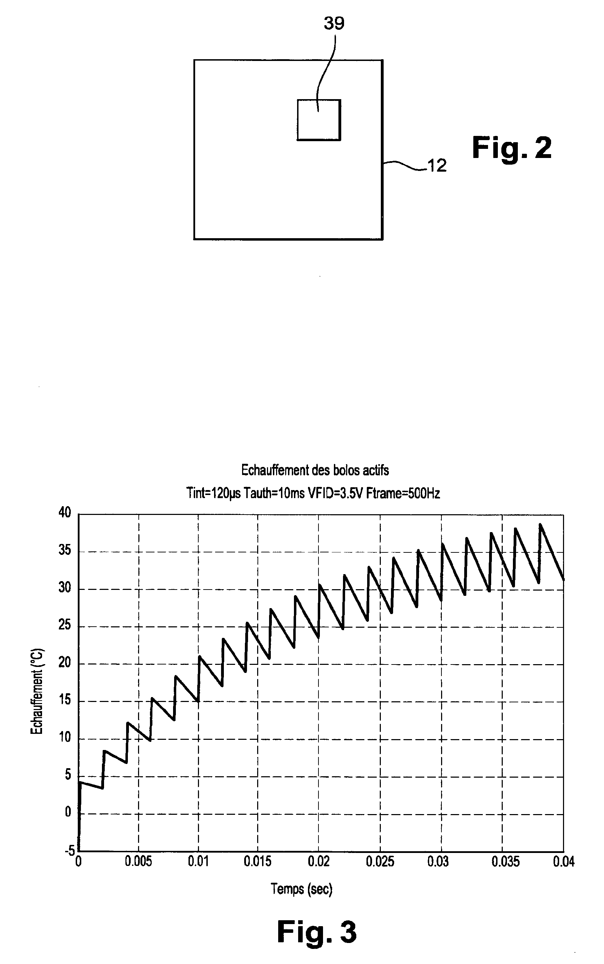

Selon un premier mode de réalisation de l'invention, le circuit de lecture **15** est apte à mettre en oeuvre une lecture par fenêtrage de la matrice **12,** c'est-à-dire apte à lire uniquement les bolomètres d'une fenêtre **39** (figure 2) quelconque de la matrice **12** en mettant en oeuvre une limitation programmée du format d'adressage, la position et les dimensions de cette fenêtre étant définies au moyen du circuit de lecture **15** selon les commandes programmées par l'utilisateur, via un lien de communication série par exemple. Le choix des dites commandes étant lui-même guidé par étalonnage de la récurrence d'adressage comme cela sera expliqué plus en détail ci-dessous. Le mode de lecture par fenêtrage est connu en soi et ne sera donc pas expliqué plus en détail pour des raisons de concision.

Il est à noter que la commande de la résistance d'un bolomètre particulier est réalisée dès lors que le circuit de lecture **15** est capable de sélectionner un nombre de lignes approprié, voire même une seule ligne si la commande le nécessite, et d'adresser ces lignes sélectionnées de manière récurrente à la fréquence trame choisie.

Dans le cas d'un mode de lecture ligne par ligne de la matrice **12,** tous les pixels d'une même ligne sont adressés simultanément, il n'y a donc pas de bénéfice en termes de temps de traitement selon l'invention, à limiter le nombre de colonnes de la fenêtre en dessous du nombre de colonnes N de la matrice **12.** Cependant, l'utilisateur peut préférer n'appliquer la polarisation que sur une fenêtre dont le nombre de colonnes est inférieur à N. Par exemple, dans le but de limiter encore plus la consommation liée à la mise en oeuvre de l'invention, bien que cette consommation soit déjà fort limitée par rapport à l'état de la technique lorsqu'une fenêtre comprend les N colonnes de la matrice, ou encore éviter d'appliquer le cycle thermique de correction aux bolomètres situés sur les mêmes lignes, mais ne nécessitant pas de correction.

Le circuit de lecture conforme à l'invention comporte donc au minimum une fonction de fenêtrage programmable selon une seule dimension, à savoir le nombre et la position des lignes sélectionnées, formant donc une bande « horizontale ». Il suffit par exemple dans ce cas de programmer par exemple par lien série le numéro de la première ligne et le nombre de lignes L à adresser à chaque trame. Dans le cas où il est préféré un fenêtrage selon deux dimensions inférieures au nombre maximal de lignes et de colonnes, pour les raisons précédentes de consommation ou/et de polarisation uniquement des bolomètres inscrits dans la fenêtre, ledit circuit de lecture conforme à l'invention nécessite par exemple un interrupteur supplémentaire inséré en série avec l'interrupteur **24,** dont la commande est activée par colonne. Cet interrupteur sera activé en condition fermée dans les colonnes à corriger, et en position ouverte dans les colonnes ne nécessitant pas de correction. Il n'est pas nécessaire de détailler davantage cette disposition particulière qui sera facilement mise en place par l'homme de métier au niveau de la conception du circuit de lecture.

Il doit être compris par ailleurs que le circuit de lecture **15** tel que précédemment décrit n'est proposé qu'à titre exemplatif, étant entendu que n'importe quel type de circuit de lecture à polarisation en tension, à lecture balayée ligne par ligne et à fenêtrage programmable fournit tous les moyens de mise en oeuvre de l'invention.

Usuellement, comme cela a été précédemment décrit, le circuit de lecture **15** lit la matrice **12,** ou la fenêtre **39** de celle-ci, ligne par ligne à une fréquence de trame prédéterminée, classiquement 30 ou 60 Hz.

Enfin, le détecteur comprend un obturateur mécanique (non représenté) coupant le flux incident sur la matrice **12,** comme cela est connu en soi.

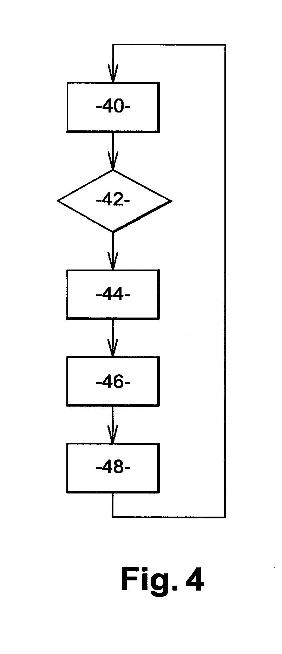

La figure 4 est un organigramme d'un procédé de réduction de la rémanence induite par exemple par une surexposition de bolomètres de la matrice **12.**

Lors d'une première étape **40,** une détection de bolomètres surexposés de la matrice **12** est mise en oeuvre. Par exemple, les bolomètres dont le signal de sortie hors éclairement de scène dans les conditions de référence prédéterminée (température du plan focal donnée, obturateur fermé) diffère d'une valeur de seuil prédéterminée d'un niveau continu dit de référence, sont considérés comme surexposés. Le signal de sortie dans de telles conditions est usuellement désigné comme le niveau continu (NC) des bolomètres. Le niveau continu de référence est choisi égal à la moyenne des niveaux continus des bolomètres de la matrice **12,** les bolomètres surexposés étant donc ceux dont le niveau continu s'écarte du niveau moyen observé.

De manière plus générale, ces bolomètres seront dits par la suite « à corriger ». En effet, il convient de noter que l'application du procédé selon l'invention modifie la résistance (et donc le NC) des bolomètres détectés lors de l'étape **40,** en particulier, mais non limitativement par suite d'une période de surexposition.

S'il existe des bolomètres à corriger (étape de test **42),** l'obturateur est fermé en **44** ou bien une défocalisation de l'image de la scène est mise en oeuvre.

En **46,** une fenêtre est alors sélectionnée autour du ou des pixel(s) à corriger. La position et les dimensions de cette fenêtre, et plus particulièrement son nombre de lignes L, sont choisies en premier lieu en fonction de la répartition spatiale des bolomètres à corriger, de manière à les corriger éventuellement tous lors d'une unique phase de correction, si la fréquence trame fₜᵣₐₘₑ jugée nécessaire à leur correction le permet. En effet, la contrainte fₜᵣₐₘₑ ≤ f_{ligne}/L doit être satisfaite. Si la fenêtre est trop étendue, plusieurs applications successives du procédé peuvent être nécessaires, de manière à couvrir l'ensemble de la ou des zones concernées.

Le nombre d'adressages des bolomètres, à une fréquence fₜᵣₐₘₑ donnée, pour parvenir à une limitation ou une élimination des phénomènes de rémanence est par exemple déterminé lors d'une étude préliminaire, effectuée en usine sur des bolomètres de test, qu'on a appelée plus haut étalonnage. Ce nombre dépend notamment de la polarisation des bolomètres **14,** de leur conception (c'est-à-dire leurs caractéristiques physiques), et de la température atteinte lors de la procédure d'adressage récurrent. Les principaux paramètres dits de conception sont la résistance électrique, la résistance thermique Rth, le coefficient TCR de variation en température de la résistance, la capacité thermique Cth).

Un étalonnage empirique consiste typiquement à soumettre délibérément dans une première phase une rétine sensible de référence (de test) à une surexposition particulière, en termes de puissance radiative et de durée, et à mesurer le décalage initial de niveau continu qui en résulte. L'étalonnage consiste à mesurer ensuite, pour une fréquence ligne prédéterminée, l'évolution temporelle du décalage de niveau continu après application d'un adressage récurrent à une fréquence trame fₜᵣₐₘₑ donnée, et ceci pour plusieurs durées d'application du procédé (plusieurs nombres de récurrences) de manière à obtenir si nécessaire la cinétique de modification de la résistance. L'ensemble du processus est alors recommencé avec une fréquence trame différente, jusqu'à obtenir suffisamment de points empiriques d'étalonnage de la résistance finale selon les paramètres du procédé.

Les dimensions du fenêtrage appliqué pendant cette phase d'étalonnage ne sont pas importantes, dès l'instant où le nombre de lignes choisi ne limite pas la gamme de fréquences trame que l'on entend explorer. La sélection d'une seule ligne, comme déjà indiqué, donne accès à la fréquence trame la plus élevée. Il en résulte l'information recherchée du nombre de récurrences à appliquer en fonction de la fréquence trame pour obtenir par exemple l'effacement de 90% du décalage de niveau continu initial.

Cette opération d'étalonnage peut être reconduite avec un décalage de niveau continu initial préalable différent (c'est-à dire des conditions de surexposition différentes), jusqu'à obtenir un abaque contenant l'information nécessaire pour la programmation de la fréquence trame d'application, dans l'ensemble des cas raisonnablement utiles (c'est à dire tant que les éléments sensibles ne sont pas détruits) d'application de l'invention.

Le comportement de la valeur de la résistance d'un bolomètre **14** (et par suite, de son niveau continu) après le retour du bolomètre à la température opératoire du plan focal consécutif une phase de correction selon l'invention, est essentiellement déterminé par la température à laquelle est porté le bolomètre pendant la phase de correction.

Il est donc possible de simplifier la phase d'étalonnage, en appliquant une série limitée de conditions particulières de fréquences de récurrence, destinées à produire une série prédéterminée de valeurs d'échauffement du bolomètre **14.** Ces valeurs sont par exemple évaluées par mesure directe ou par simulation numérique.

L'estimation de ladite température est simple à obtenir à l'aide d'une modélisation thermique, à partir des paramètres connus de conception du bolomètre et des paramètres d'excitation Joule. Un exemple de résultat de modélisation thermique dans un cas représentatif est présenté en figure 3.

Par contre, le comportement temporel en termes de résistance électrique, c'est-à-dire l'évolution de niveau continu après retour à la température ambiante (ou la température opérationnelle du plan focal) qui résulte d'un cycle thermique de correction donné, par exemple selon l'invention, appliqué après une période de surexposition, en fonction de la température précédemment estimée, dépend en particulier du matériau sensible mis en oeuvre. Il n'est donc pas possible ni même utile de proposer ici une forme générale d'expression analytique qui modéliserait ce comportement. Cependant, lorsque tous les paramètres de surexposition d'une part, de processus de réduction de rémanence d'autre part sont fixés, on observe que le comportement est suffisamment déterministe (reproductible), d'autant plus qu'il n'est pas besoin de précision pour obtenir l'effet recherché, pour être applicable à tous les produits construits à partir du même type de bolomètre élémentaire.

Il est en conséquence pertinent d'appliquer une relation analytique simple, basée sur l'acquisition empirique évoquée précédemment, qui fournit très rapidement et pour une large gamme de conditions initiales un ordre de grandeur de la fréquence de récurrence et du nombre de récurrences (la durée de la phase d'adressage récurrent) à appliquer préférentiellement, selon par exemple le choix des conditions opératoires les plus pratiques, ou les plus rapides pour parvenir au but recherché.

Toujours en **46,** la fréquence ligne utilisée pour l'adressage ligne par ligne des L lignes la fenêtre **39** est choisie constante et égale à la fréquence ligne f_{ligne} utilisée lors de la lecture plein format de la matrice **12,** et la fréquence de trame est choisie selon le résultat de l'étalonnage, sous la contrainte fₜᵣₐₘₑ ≤ f_{ligne}/L, de manière à obtenir le résultat recherché en termes de résistance finale (du NC final) après retour à la température opératoire. En effet, en conservant la fréquence ligne et en raison du nombre restreint de lignes dans la fenêtre **39,** une augmentation de la fréquence de trame, et donc de la récurrence d'adressage des bolomètres de cette fenêtre, est rendu possible.

Une fois la fenêtre et la fréquence de trame sélectionnées, un adressage ligne par ligne de celle-ci est réalisé par le circuit de lecture **15** à la fréquence ligne f_{ligne} utilisée pour la lecture plein format de la matrice **12,** pendant une durée prédéterminée définie par exemple selon un critère empirique comme exposé précédemment. L'application de la fréquence trame fₜᵣₐₘₑ choisie est typiquement obtenue au moyen de la commande digitale de synchronisation trame habituellement prévue dans tous les circuits de lecture, comme précédemment indiqué.

Le profil de la température d'un bolomètre de la fenêtre sélectionné est illustré à la figure 3.

Ce profil alterne des périodes d'augmentation quasi-linéaire de la température du bolomètre, pendant lesquelles le bolomètre est adressé, avec des périodes de refroidissement libre du bolomètre, pendant lesquelles le bolomètre n'est pas adressé.

Comme on peut le constater, la température moyenne du bolomètre augmente du fait d'une fréquence d'adressage élevée de celui-ci. En effet, la fenêtre comprend un nombre réduit de lignes en comparaison du plein format de la matrice **12.** En conséquence, le balayage de l'ensemble de ces lignes est rapide, une même ligne étant lue de nouveau avant refroidissement complet des bolomètres de celle-ci.

De fait, la température moyenne (telle que considérée sur la durée d'un temps ligne) augmente. Au-delà d'un nombre d'adressages supérieur à environ 3 fois la constante de temps thermique du bolomètre, c'est-à-dire typiquement 15 à 30 millisecondes, la température moyenne (sur un temps ligne) n'augmente plus. Cette stabilisation est le résultat de l'équilibre entre la puissance électrique efficace dissipée par effet Joule dans le bolomètre, et les pertes thermiques, principalement par conduction vers le substrat resté à sa température de départ.

En se référant de nouveau à la figure 4, le procédé se poursuit en **48** par la fin de la lecture récurrente de la fenêtre et l'ouverture de l'obturateur, puis reboucle sur l'étape **40** de détection. La rémanence des bolomètres surexposés est ainsi réduite en amplitude et en durée, voire éliminée.

De cette manière il est obtenu après retour au mode normal ordinaire de fonctionnement, disponible immédiatement puisque sans changement de la température du plan focal, un décalage de niveau continu négligeable, ou à tout le moins inférieur à un seuil de différence prédéterminé acceptable pour un fonctionnement nominal des bolomètres sélectionnés par rapport aux autres bolomètres de la matrice.

Il a été décrit un mode de réalisation dans lequel, une fenêtre de dimensions fixes comprenant des pixels à corriger est sélectionnée.

En variante, lors de la procédure de réduction des phénomènes de rémanence, les dimensions de la fenêtre varient au cours du temps, ou la fréquence trame varie au cours du temps. Le profil temporel de la température moyenne des bolomètres à corriger peut ainsi être commandé avec précision. En conséquence, la résistance finale est commandée avec précision. Par exemple, une fréquence trame élevée est sélectionnée dans un premier temps, afin d'obtenir une élévation moyenne importante de la température, puis une fréquence trame plus faible est ensuite sélectionnée dans un second temps afin d'obtenir un accroissement de la température moyenne (par rapport à la température initiale) plus modéré. La température moyenne des bolomètres est ainsi ajustée graduellement. En relation, le nombre de lignes L de la fenêtre balayée peut être adapté si nécessaire entre le premier et le second temps, de manière à assurer la compatibilité entre le nombre de lignes L et la fréquence trame : fₜᵣₐₘₑ ≤ f_{ligne}/L.

De même il a été décrit un mode de réalisation dans lequel le temps d'adressage ou d'intégration est inchangé par rapport au fonctionnement nominal. En variante, le temps d'adressage ou d'intégration est également modifié.

De même il a été décrit un mode de réalisation dans lequel la tension de polarisation des bolomètres est inchangée par rapport au fonctionnement nominal. En variante, la tension de polarisation est également modifiée.

De même il a été décrit un mode de réalisation dans lequel, le module à effet Peltier, lorsqu'il existe, n'est pas utilisé pour chauffer le plan focal. En variante, ce module à effet Peltier est également utilisé.

De même il a été décrit un mode de réalisation dans lequel la matrice de bolomètre est lue ligne par ligne. L'invention s'applique également aux matrices de bolomètres lues pixel par pixel. Dans un tel cas, le circuit de lecture est apte adresser individuellement les pixels séquentiellement un par un de manière dite sérielle.

Les mêmes avantages que ce qui est précédemment décrit dans le cas de la lecture ligne par ligne seront obtenus d'un tel circuit à lecture sérielle pourvu d'une fonction de fenêtrage d'une série de pixels contigus. L'ajustement de la fréquence trame rendu possible par le nombre réduit de pixels à lire, conduit à un ajustement de la résistance des pixels adressés à ladite fréquence trame après retour aux conditions thermiques ordinaires.

La condition à satisfaire entre l'extension de la fenêtre et la fréquence trame accessible devient dans ce cas f_{frame} ≤ fₚᵢₓₑₗ/P, où P est le nombre de pixels de la fenêtre. La température la plus élevée est obtenue par l'adressage d'un unique pixel (bolomètre) à une fréquence trame N x M fois plus élevée que la fréquence trame nominale du plein format de la matrice.

Bien entendu, on comprendra que l'invention ne se limite pas au détecteur bolométrique décrit en relation avec la figure 1, mais s'applique à tout type de détecteur bolométrique.

Il a été décrit une application privilégiée de l'invention à la correction de rémanence. Bien entendu, l'invention peut s'envisager pour d'autres applications nécessitant une modification de la résistance des bolomètres.

Grâce à l'invention, il est ainsi obtenu les avantages suivants :
- le temps pendant lequel le détecteur est indisponible est limité. En effet, en quelques dizaines de millisecondes, on observe déjà une réduction substantielle, voire une élimination complète, des phénomènes de rémanence ;
- la consommation électrique induite par la mise en oeuvre du procédé selon l'invention est réduite. En effet, la réduction des phénomènes de rémanence mise en oeuvre selon l'invention ne nécessite pas l'utilisation de matériel grand consommateur d'énergie, comme un module à effet Peltier par exemple ;
- le procédé selon l'invention ne modifie ni la température du plan focal (au premier ordre), ni les caractéristiques de courant (polarisation, temps d'intégration). Les tables utilisées pour la correction des dispersions de gains et d'offsets dans la matrice demeurent donc valables dès la fin du processus de correction des résistances ;
- une efficacité accrue de la réduction des phénomènes de rémanence est obtenue, car les températures accessibles grâce à l'invention sont supérieures à ce que procure l'état antérieur de la technique, et par ailleurs applicable de manière conjointe (cumulée) avec un d'ajustement du temps d'intégration, ou/et de la tension de polarisation des bolomètres, ou/et la mise en oeuvre du module Peltier, s'il s'en trouve un ;
- la conception des détecteurs bolométriques reste inchangée puisque aucune de leurs caractéristiques, comme la polarisation des bolomètres ou le temps d'intégration (qui correspond dans la majorité des cas au temps d'adressage), n'a besoin d'être modifiable ; et
- une altération de la durée de vie ou de la fiabilité du détecteur est particulièrement modérée par le fait qu'aucune sollicitation électrique et thermique n'est imposée aux éléments du boîtier, et du fait qu'une très faible partie des éléments internes à l'enceinte sous vide est thermiquement concernée par une correction, de surcroît localisée, des phénomènes de rémanence.

## Revendications

1. Procédé de réduction d'une rémanence affectant une matrice de bolomètres (12) d'un détecteur, ledit détecteur comportant un circuit de lecture (15) de ladite matrice apte à adresser chaque bolomètre (22) de la matrice (12), ***caractérisé* en ce qu'**il comporte :
▪ une étape (40) de sélection d'un bolomètre (22) selon une comparaison entre son niveau continu et la moyenne des niveaux continus de l'ensemble des bolomètres de la matrice (12), le bolomètre étant sélectionné si cette différence est supérieure à un seuil prédéterminé ;
▪ une étape (46) de réglage du niveau continu du bolomètre sélectionné (22), comportant :
∘ la sélection au moyen du circuit de lecture (15) d'une fenêtre de la matrice de bolomètres (12), ladite fenêtre comprenant le bolomètre sélectionné (22) et ayant un nombre de lignes L inférieur au nombre N total de lignes de la matrice de bolomètres ;
∘ la sélection au moyen du circuit de lecture (15) d'une fréquence trame fₜᵣₐₘₑ telle que fₜᵣₐₘₑ ≤ f_{ligne}/L et correspondant à une récurrence d'adressage souhaitée de manière à ce que chaque ligne de la fenêtre est lue de nouveau avant le refroidissement complet des bolomètres de celle-ci, où f_{ligne} est une fréquence ligne prédéterminée ; et
∘ la sélection d'un nombre d'adressages N pour la fréquence trame fₜᵣₐₘₑ sélectionnée de manière à obtenir un décalage entre le niveau continu du bolomètre sélectionné (22) et la moyenne des niveaux continus de l'ensemble des bolomètres de la matrice (12) inférieur à un seuil prédéterminé ; et
o l'application de N adressages consécutifs par le circuit de lecture (15) des L lignes de la fenêtre sélectionnée à la fréquence de trame fₜᵣₐₘₑ, et à la fréquence ligne f_{ligne} prédéterminée.

2. Procédé selon la revendication 1, ***caractérisé* en ce que** le nombre d'adressages N est sélectionné par interrogation d'un abaque associant, pour la fréquence ligne, des nombres d'adressages à des valeurs de décalage de niveau continu, et de fréquence trame, , déterminé lors d'une opération d'étalonnage en usine, l'interrogation de l'abaque étant réalisée en fonction du décalage de niveau continu mesuré du bolomètre sélectionné (22), et de la fréquence trame fₜᵣₐₘₑ sélectionnée.

3. Procédé selon l'une quelconque des revendications précédentes, ***caractérisé* en ce que** lors du réglage de la récurrence d'adressage du bolomètre, un obturateur équipant le détecteur est fermé ou bien une défocalisation est mise en oeuvre.

4. Procédé selon l'une quelconque des revendications précédentes, ***caractérisé* en ce que** la récurrence d'adressage est variable et comporte au moins une première et une seconde phase, la valeur de la récurrence d'adressage dans la première phase étant différente de la valeur de la récurrence d'adressage dans la seconde phase.

5. Procédé selon l'une quelconque des revendications précédentes, ***caractérisé* en ce que** les caractéristiques de polarisation du bolomètre ne sont pas modifiées.

6. Procédé selon l'une quelconque des revendications 1 à 4, ***caractérisé* en ce qu'**il comporte en outre une étape de modification des caractéristiques de polarisation du bolomètre, notamment sa tension de polarisation.

7. Procédé selon l'une quelconque des revendications précédentes, ***caractérisé* en ce qu'**il comporte en outre une étape de modification de la durée au cours de laquelle le bolomètre est parcouru par un courant lors de l'adressage de celui-ci.

8. Procédé selon l'une quelconque des revendications précédentes, ***caractérisé* en ce qu'**il comporte en outre une étape de chauffage du bolomètre par une source de chaleur externe à celui-ci, notamment une source de chaleur du type Peltier.

9. Détecteur bolométrique comprenant une matrice de bolomètres (12) et un circuit de lecture (15) de la matrice (12), apte à adresser chaque bolomètre (22) de celle-ci, ***caractérisé* en ce que** le circuit de lecture (15) est apte à régler la résistance de chaque bolomètre (22) de la matrice (12) par un réglage de la récurrence d'adressage de celui-ci, et en qu'il est apte à mettre en oeuvre un procédé conforme à l'une quelconque des revendications 1 à 8.

## Patentansprüche

1. Verfahren zur Verringerung einer Remanenz betreffend eine Bolometermatrix (12) eines Detektors, wobei der Detektor eine Leseschaltung (15) der Matrix aufweist, die geeignet ist, sich an jeden Bolometer (22) der Matrix (12) zu richten, **dadurch gekennzeichnet, dass** es folgendes aufweist:
- einen Schritt (40) der Auswahl eines Bolometers (22) nach einem Vergleich zwischen seinem kontinuierlichen Niveau und dem Mittelwert der kontinuierlichen Niveaus der Gesamtheit der Bolometer der Matrix (12), wobei der Bolometer ausgewählt wird, wenn diese Differenz größer ist als ein vorbestimmter Schwellenwert;
- einen Schritt (46) der Einstellung des kontinuierlichen Niveaus des ausgewählten Bolometers (22), der folgendes aufweist:
- die Auswahl eines Fensters der Bolometermatrix (12) mit Hilfe einer Leseschaltung (15), wobei das Fenster den ausgewählten Bolometer (22) aufweist und eine Anzahl Zeilen L besitzt, die geringer ist als die Gesamtzahl N der Zeilen der Bolometermatrix;
- die Auswahl einer Bildfrequenz fₜᵣₐₘₑ wie fₜᵣₐₘₑ ≤f_{ligne}/L mit Hilfe der Leseschaltung (15) und entsprechend einer gewünschten Wiederholung der Adressierung, so dass jede Zeile des Fensters vor der vollständigen Kühlung der Bolometer desselben erneut gelesen wird, wobei f_{ligne} eine vorbestimmte Zeilenfrequenz ist; und
- die Auswahl einer Anzahl N von Adressierungen für die ausgewählte Bildfrequenz fₜᵣₐₘₑ, so dass man zwischen dem kontinuierlichen Niveau des ausgewählten Bolometers (22) und dem Mittelwert der kontinuierlichen Niveaus der Gesamtheit der Bolometer der Matrix (22) eine Verschiebung erhält, die niedriger ist als ein vorbestimmter Schwellenwert; und
- die Anwendung von N aufeinanderfolgenden Adressierungen durch die Leseschaltung (15) der L Zeilen des ausgewählten Fensters auf die vorbestimmte Bildfrequenz fₜᵣₐₘₑ und die vorbestimmte Zeilenfrequenz f_{ligne}.

2. Verfahren nach Anspruch 1, **dadurch gekennzeichnet, dass** die Anzahl N der Adressierungen ausgewählt ist durch Abfrage eines zugehörigen Schaubildes bezüglich der Zeilenfrequenz, der Anzahl der Adressierungen der Werte der Verschiebung des kontinuierlichen Niveaus und der Bildfrequenz, bestimmt durch Kalibrierung im Werk, wobei die Abfrage des Schaubildes in Abhängigkeit von der Verschiebung des gemessenen kontinuierlichen Niveaus des ausgewählten Bolometers (22) und der ausgewählten Bildfrequenz fₜᵣₐₘₑ durchgeführt wird.

3. Verfahren nach einem der vorhergehenden Ansprüche, **dadurch gekennzeichnet, dass** bei der Einstellung der Wiederholung der Adressierung des Bolometers eine Blende, mit der der Detektor ausgestattet ist, geschlossen wird, ohne eine Defokussierung durchgeführt wird.

4. Verfahren nach einem der vorhergehenden Ansprüche, **dadurch gekennzeichnet, dass** die Wiederholung der Adressierung variabel ist und mindestens eine erste und eine zweite Phase aufweist, wobei sich der Wert der Wiederholung der Adressierung in der ersten Phase von dem Wert der Wiederholung in der zweiten Phase unterscheidet.

5. Verfahren nach einem der vorhergehenden Ansprüche, **dadurch gekennzeichnet, dass** die Merkmale der Polarisation des Bolometers nicht verändert werden.

6. Verfahren nach einem der Ansprüche 1 bis 4, **dadurch gekennzeichnet, dass** es darüberhinaus einen Schritt der Veränderung der Merkmale der Polarisation des Bolometers, insbesondere seiner Polarisationsspannung, aufweist.

7. Verfahren nach einem der vorhergehenden Ansprüche, **dadurch gekennzeichnet, dass** es darüberhinaus einen Schritt der Veränderung der Dauer aufweist, in der während der Adressierung des Bolometers ein Strom durch den Bolometer fließt.

8. Verfahren nach einem der vorhergehenden Ansprüche, **dadurch gekennzeichnet, dass** es darüberhinaus einen Schritt des Erhitzens des Bolometers durch eine gegenüber dem Bolometer externe Wärmequelle, insbesondere eine Peltier-Wärmequelle, aufweist.

9. Bolometrischer Detektor, aufweisend eine Bolometermatrix (12) und eine Leseschaltung (15) der Matrix, die geeignet ist, sich an jeden Bolometer (22) dieser Matrix zu richten, **dadurch gekennzeichnet, dass** die Leseschaltung (15) geeignet ist, den Widerstand jedes Bolometers (22) der Matrix (12) durch eine Einstellung der Wiederholung der Adressierung desselben zu regeln, und dass er geeignet ist, ein Verfahren nach einem der Ansprüche 1 bis 8 durchzuführen.

## Claims

1. A method for reducing the remanence of a matrix of bolometers (22) of a sensor, said sensor comprising a circuit for reading (15) said matrix which is capable of addressing each bolometer of said matrix, ***characterised* in that** it comprises
• a step (40) for selecting one bolometer (22) according to a comparison between its continuous level and the average of the continuous levels of the bolometers of the matrix (12), said bolometer being selected provided that the difference exceeds to a predetermined threshold ;
• a step (46) of adjusting the continuous level of the selected bolometer (22), comprising :
- selecting by means of the read circuit (15) a window of the bolometer matrix (12), said window including the selected bolometer (22) and having a number of lines L smaller than the total number N of lines in the bolometer matrix;
- selecting by means of the read circuit (15) a frame rate f_{frame} such that f_{frame} ≤ fₗᵢₙₑ/L and corresponding to the required recurrence of addressing in order that each line of the window is read another time before the complete cooling of the bolometers of said window, where fₗᵢₙₑ is a predetermined line rate;
- selecting a number N of addressing for the selected frame rate f_{frame} in order to obtain an offset between the continuous level of the selected bolometer (22) and the average of the continuous levels of the bolometers of the matrix (12) smaller than a predetermined threshold ; and
- applying N consecutive addressings by the read circuit (15) of the L lines of the selected window at the predetermined frame rate f_{frame} and at the line rate fₗᵢₙₑ.

2. The method as claimed in claim 1, ***characterised* in that** the number of addressings N is selected by querying of a chart combining, for the line rate, numbers of addressings to values of continuous level offset and with a frame rate, determined during a plant calibration, the query of the chart being done based on the measured continuous level offset of the selected bolometer (22) and on the selected frame rate f_{frame}.

3. The method as claimed in any one of the previous claims, ***characterised* in that** when the recurrence of addressing the bolometer is adjusted, the method comprises a step of closing a shutter fitted to the sensor or the method comprises a defocusing step.

4. The method as claimed in any one of the previous claims, ***characterised* in that** the recurrence of addressing is variable and comprises at least one first and one second phase, the value of the recurrence of addressing in the first phase being different from the value of the recurrence of addressing in the second phase.

5. The method as claimed in any one of the previous claims, ***characterised* in that** the polarisation characteristics of the bolometer remain unchanged.

6. The method as claimed in any one of the claims 1 to 4, ***characterised* in that** it further comprises a step of modifying the polarisation characteristics of the bolometer, and in particular its polarisation voltage.

7. The method as claimed in any one of the preceding claims, ***characterised* in that** it further comprises a step of modifying the length of time during which the bolometer is passed through by a current during the addressing thereof.

8. The method as claimed in any one of the previous claims, ***characterised* in that** it further comprises a step of heating the bolometer using a heat source external thereto, and in particular a heat source of the Peltier type.

9. A bolometric detector including a bolometer matrix (12) and a circuit for reading (15) the matrix (12), which is capable of addressing each bolometer (22) thereof, ***characterised* in that** the read circuit (15) is capable of adjusting the resistance of each bolometer (22) in the matrix (12) by adjusting the recurrence of addressing thereof, and **in that** it is able to carry on the method according to any one of claims 1-8.
